(19) Europäisches Patentamt
European Patent Office
Office européen des brevets

(11) **EP 3 135 556 A1**

(12) **EUROPEAN PATENT APPLICATION**
published in accordance with Art. 153(4) EPC

(43) Date of publication:
**01.03.2017 Bulletin 2017/09**

(21) Application number: **14890212.5**

(22) Date of filing: **21.04.2014**

(51) Int Cl.:
***B61L 27/00*** (2006.01)      ***G08G 1/00*** (2006.01)

(86) International application number:
**PCT/JP2014/061114**

(87) International publication number:
**WO 2015/162652 (29.10.2015 Gazette 2015/43)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**

(71) Applicant: **Hitachi, Ltd.**
**Chiyoda-ku**
**Tokyo 100-8280 (JP)**

(72) Inventors:
• **MUTO Kazuo**
**Tokyo 100-8280 (JP)**

• **MIYAUCHI Tsutomu**
**Tokyo 100-8280 (JP)**
• **SUZUKI Motonari**
**Tokyo 100-8280 (JP)**
• **FUJIWARA Masayasu**
**Tokyo 100-8280 (JP)**

(74) Representative: **Gill, Stephen Charles et al**
**Mewburn Ellis LLP**
**City Tower**
**40 Basinghall Street**
**London EC2V 5DE (GB)**

(54) **TRAFFIC SYSTEM OPTIMIZATION DEVICE**

(57)     In order to provide a device capable of flexibly responding to a change in a constraint in a traffic system, a traffic system optimization device according to the present invention includes: an optimization condition setting means that has a function of designating a condition as a range on a map when specifications of a traffic system are optimized; an optimization execution means that optimizes the specifications of the traffic system by a simulation using a calculator under an optimization condition set by the optimization condition setting means; an optimization result analysis means that groups optimal solutions analogous to each other obtained by the optimization execution means; and an analysis result display means that has at least a function of displaying a range of a design variable for each group of an optimal solution grouped by the optimization result analysis means on the map.

## FIG. 1

EP 3 135 556 A1

**Description**

Technical Field

The present invention relates to a technology for optimizing specifications of a newly constructed traffic system by a simulation using a calculator.

Background Art

As a conventional technology for supporting optimization of a railroad system, there is a technology related to a train service simulation device capable of displaying energy consumption of a substation or a train running pattern in specific specifications (for example, see PTL 1).

In addition, as a conventional technology for a traffic flow simulation, there is a technology for estimating a demand traffic volume approximate to an actual traffic volume using a travel time obtained on a congested road based on an ideal travel time obtained by calculation and an actual travel time measured on the road in a specific section, and performing a traffic flow simulation based on the estimated demand traffic volume (for example, see PTL 2).

Citation List

Patent Literature

PTL 1: JP 2006-254536 A
PTL 2: JP 2013-137715 A

Summary of Invention

Technical Problem

A traffic system of a railroad, a monorail, a surface car, etc. involves a high initial cost for infrastructure development and a high running cost for infrastructure maintenance. Therefore, there is a desire to construct a traffic system that ensures a required transport volume at an initial cost and running cost as low as possible.

With regard to the above object, for example, a train service simulation device capable of displaying energy consumption of a substation or a train running pattern in specific specifications has been proposed as described in PTL 1 to support optimization of a railroad system which is a traffic system.

However, a traffic system such as a railroad system is complex, and the number of design parameters is significantly large. Thus, a user has difficulty in determining optimum specifications of the railroad system through a manual operation from a result of the train service simulation device. In addition, various constraints are present in designing the railroad system, and there is difficulty in performing optimization by taking all the constraints into consideration in advance. It is a problem to provide a device capable of flexibly responding to a change in a constraint in the traffic system.

Solution to Problem

In order to solve the above issue, for example, a traffic system optimization device according to the present invention includes: an optimization condition setting unit that has a function of designating a condition as a range on a map when specifications of a traffic system are optimized; an optimization execution unit that optimizes the specifications of the traffic system by a simulation using a calculator under an optimization condition set by the optimization condition setting unit; an optimization result analysis unit that groups optimal solutions analogous to each other obtained by the optimization execution unit; and an analysis result display unit that has at least a function of displaying a range of a design variable for each group of an optimal solution grouped by the optimization result analysis unit on the map.

Advantageous Effects of Invention

According to the invention, it is possible to support selection of optimum specifications of a traffic system, and to flexibly respond to a change in a constraint when the change is present.

Brief Description of Drawings

[FIG. 1] FIG. 1 is a diagram for description of a configuration of a traffic system optimization device according to the invention.

[FIG. 2] FIG. 2 is a diagram for description of a first example of the traffic system optimization device according to the invention.

[FIG. 3] FIG. 3 is a diagram illustrating an example of a flowchart of a flow of data according to the first example of the traffic system optimization device according to the invention.

[FIG. 4] FIG. 4 is a diagram illustrating an example of a flowchart of a flow of processing according to the first example of the traffic system optimization device according to the invention.

[FIG. 5] FIG. 5 is a diagram illustrating examples of user interfaces provided by a design parameter setting means 210, a constraint condition setting means 220, and an objective function setting means 230 according to the first example of the traffic system optimization device according to the invention.

[FIG. 6] FIG. 6 is a diagram illustrating an example of a screen of a pareto solution display means 290 according to the first example of the traffic system optimization device according to the invention.

[FIG. 7] FIG. 7 is a diagram illustrating an example of a screen of an optimal solution details display means 2100 according to the first example of the traffic system optimization device according to the invention.

[FIG. 8] FIG. 8 is a diagram for description of a second example of the traffic system optimization device according to the invention.

[FIG. 9] FIG. 9 is a diagram illustrating an example of a flowchart of a flow of data according to the second example of the traffic system optimization device according to the invention.

[FIG. 10] FIG. 10 is a diagram illustrating an example of a flowchart of a flow of processing according to the second example of the traffic system optimization device according to the invention.

[FIG. 11] FIG. 11 is a diagram illustrating examples of user interfaces provided by a design parameter setting means 210, a constraint condition setting means 220, and an objective function setting means 230 according to the second example of the traffic system optimization device according to the invention.

[FIG. 12] FIG. 12 is a diagram illustrating an example of a screen of an optimal solution details display means 2100 according to the second example of the traffic system optimization device according to the invention.

[FIG. 13] FIG. 13 is a diagram illustrating an example of a pareto solution and a grouping result obtained by the traffic system optimization device according to the invention.

Description of Embodiments

As described above, for example, a traffic system optimization device of the invention includes an optimization condition setting unit that has a function of designating a condition as a range on a map when specifications of a traffic system are optimized, an optimization execution unit that optimizes the specifications of the traffic system by a simulation using a calculator under an optimization condition set by the optimization condition setting unit, an optimization result analysis unit that groups optimal solutions analogous to each other obtained by the optimization execution unit, and an analysis result display unit that has at least a function of displaying a range of a design variable for each group of an optimal solution grouped by the optimization result analysis unit on the map.

In the above-described configuration, the optimization condition setting unit may include a cost database in which data necessary to determine an initial cost of a railroad system such as a price of each component of the railroad system and data necessary to determine a running cost of the railroad system such as electric charges, personnel expenses, etc. are recorded, a design parameter setting unit that has a function of determining a specification to be set as a design parameter and optimized among specifications of the railroad system, and designating a range thereof on a map, a constraint condition setting unit that sets a constraint condition in optimization, and an objective function setting unit that sets an objective function in optimization. In addition, the optimization execution unit may include a parameter optimization unit, a rail service simulation unit that calculates power consumption or transportation capacity of the railroad system in a given design parameter, a cost calculation unit that calculates an initial cost or a running cost of the traffic system based on at least one of the data recorded in the cost database, a design parameter given by the parameter optimization unit, and an output of the rail service simulation unit, and an objective function calculation unit that calculates a value of an objective function according to a method of calculating an objective function set by the objective function setting unit based on at least one of an output of the rail service simulation unit and an output of the cost calculation unit. In addition, the optimization result analysis unit includes an analogous optimal solution grouping unit that groups analogous optimal solutions using a clustering method. In addition, the analysis result display unit may include a pareto solution display unit that displays a pareto solution obtained by the optimization execution unit and an optimal solution group to which each pareto solution belongs on a graph using a variable set by a user as an axis, and an optimization details display unit that displays various detailed information of each optimal solution group on a map.

In addition, in the above-described configuration, the traffic system optimization device may further include a traffic condition database in which data related to a traffic condition of a city where the traffic system is constructed is recorded. Here, the data pertains to a traffic volume in at least a portion of a traffic system component including each intersection and a road. In addition, the optimization execution unit may include a traffic movement simulator that evaluates a change in a congestion condition on a road before and after the traffic system is constructed.

Hereinafter, embodiments of the invention will be described as respective examples in detail using drawings.

Example 1

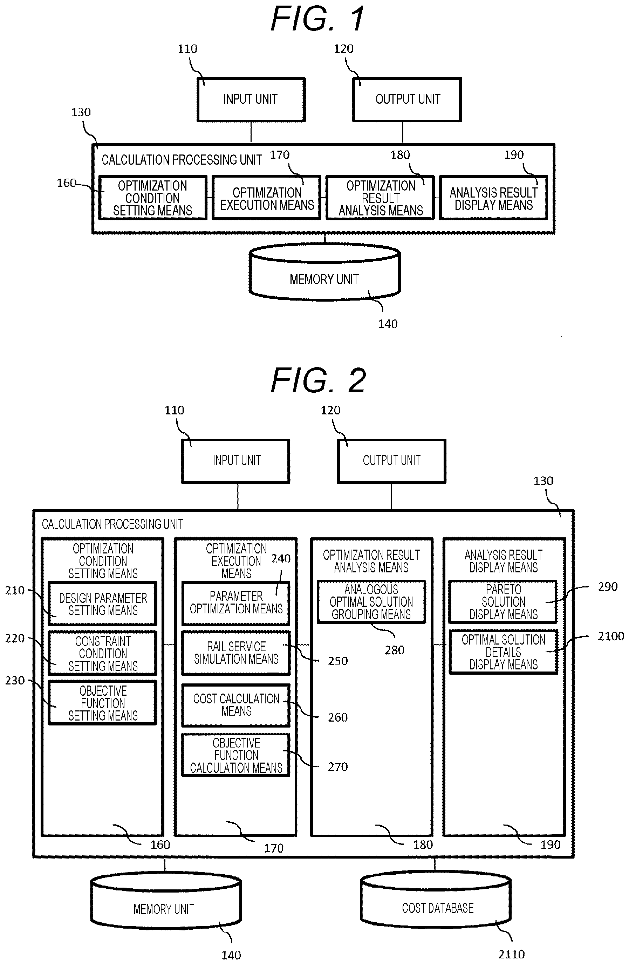

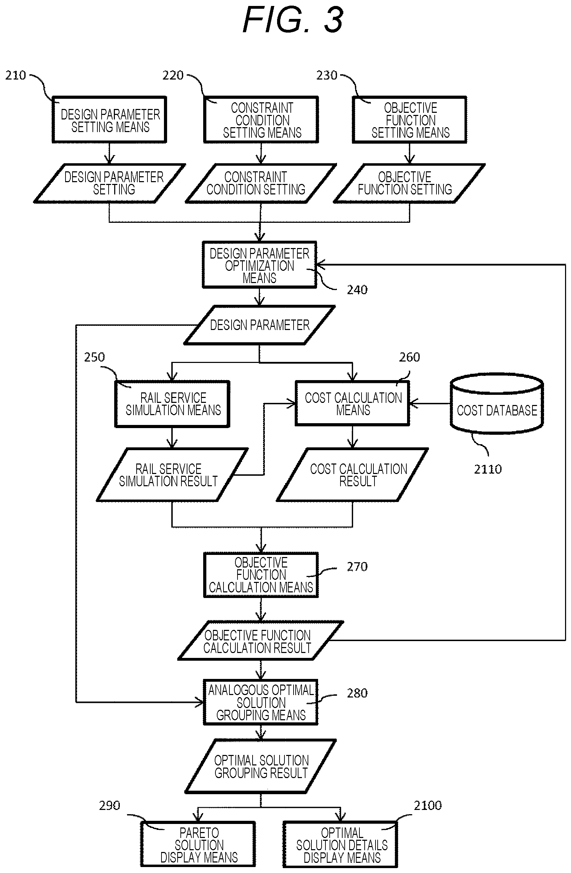

Hereinafter, a description will be given of Example 1 corresponding to a first embodiment of the invention. FIG. 2 is an example of a block diagram of a traffic system optimization device of the present example. FIG. 3 is a flow of main data of processing in the present example. In description below, a railroad system which is a traffic system will be given as an example, and a device for optimizing the railroad system will be described. However, a traffic system to be optimized by the traffic system optimization device of the invention is not restricted to the railroad system.

The traffic system optimization device in the present example mainly includes an input unit 110, an output unit 120, a calculation processing unit 130, a memory unit 140, and a cost database 2110. These units may be connected to each other through a network such as the Internet, an intranet, etc.

Specifically, the input unit 110 corresponds to a communication cable, a hard disk drive device, a CD-ROM device, a DVD device, a memory card reader, and various input devices such as a keyboard, etc., and is used when a user of the present device inputs some data to the present device.

The memory unit 140 is used to record information necessary when the present device performs calculation, a calculation result, etc.

Data necessary to determine an initial cost of the railroad system such as a price of each component of the railroad system, data necessary to determine a running cost of the railroad system such as electric charges or personnel expenses, etc. are recorded in the cost database 2110.

Specifically, the calculation processing unit 130 is a central processing unit (CPU), and executes information processing in the traffic system optimization device. An optimization condition setting means 160, an optimization execution means 170, an optimization result analysis means 180, an analysis result display means 190, etc. are executed in the calculation processing unit 130.

In the present example, the optimization condition setting means 160 includes a design parameter setting means 210, a constraint condition setting means 220, and an objective function setting means 230.

The design parameter setting means 210 provides a user interface in which a specification to be optimized by the user is set as a design parameter and a range thereof is designated when specifications of the railroad system are optimized. The design parameter setting means 210 includes at least a user interface that allows designation of a range in which a facility or an apparatus included in the railroad system can be constructed or installed on a map of a city where the railroad system is constructed.

The constraint condition setting means 220 provides a user interface for selecting a parameter corresponding to a constraint condition and inputting a maximum value or a minimum value thereof, or a user interface for inputting a constraint equation by the user when specifications of the railroad system are optimized.

The objective function setting means 230 provides a user interface for designating a calculation result as an objective function by the user among calculation results of a rail service simulation means 250 and a cost calculation means 260. In addition, it is possible to include a user interface for designating a scheme of calculating an objective function from calculation results of the rail service simulation means 250 and the cost calculation means 260. Further, a plurality of objective functions may be designated.

In addition, in the present example, the optimization execution means 170 includes a parameter optimization execution means 240, the rail service simulation means 250, the cost calculation means 260, and an objective function calculation means 270.

The rail service simulation means 250 evaluates power consumption, transportation capacity, etc. of the railroad system in a design parameter given by the parameter optimization means 240.

The cost calculation means 260 calculates an initial cost or a running cost of the traffic system based on the data recorded in the cost database 2110, the design parameter given by the parameter optimization means 240, and the result of the rail service simulation means 250.

The objective function calculation means 270 calculates a value of an objective function according to a method of calculating an objective function set by the objective function setting means 230 based on the results of the rail service simulation means 250 and the cost calculation means 260.

The parameter optimization means 240 performs multi-objective optimization to optimize a design parameter using, for example, an optimization scheme such as a widely known genetic algorithm based on a value of the design parameter or an objective function value corresponding thereto.

In addition, in the present example, the optimization result analysis means 180 includes an analogous optimal solution grouping means 280.

The analogous optimal solution grouping means 280 groups analogous optimal solutions to prepare an optimal solution group using, for example, a clustering method such as the widely known k-means method based on values of a design parameter and an objective function.

In addition, in the present example, the analysis result display means 190 includes a pareto solution display means 290 and an optimal solution details display means 2100.

The pareto solution display means 290 displays a pareto solution and an optimal solution group to which each pareto solution belongs on a graph using a variable designated by the user as an axis. A variable that can be selected as the axis may correspond to the design parameter, or may be the objective function or the constraint condition. In addition, a plurality of graphs may be simultaneously displayed. The pareto solution display means 2100 has at least a function of designating a variable serving as an axis at the time of display, and a function of distinguishably displaying an optimal solution for each optimal solution group using a marker, a color, etc.

The optimal solution details display means 2100 displays various detailed information of an optimal solution belonging to each optimal solution group. The optimal solution details display means 2100 has at least a function capable of displaying a design parameter, which is displayable on a map, on the map among design parameters of an optimal solution belonging to an optimal solution group, and displaying a range of an optimal design parameter.

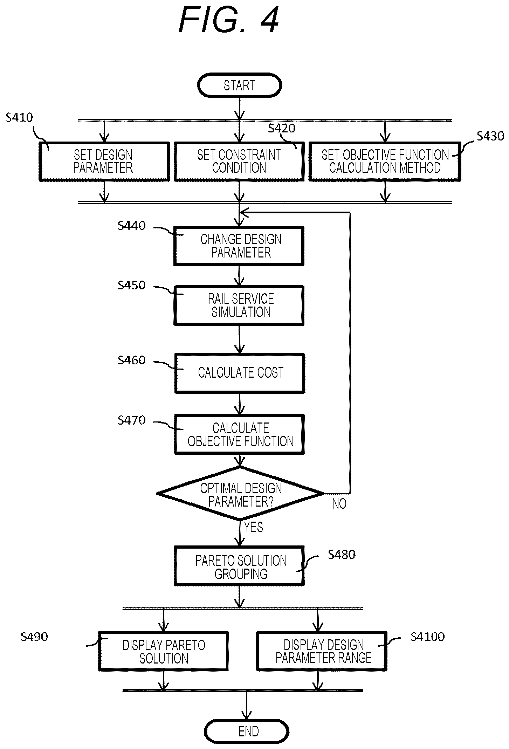

Next, a flow of processing of the present example will be described. FIG. 4 illustrates the flow of processing in the present example.

First, the user sets a design parameter, a range thereof, a constraint condition, and a method of calculating an objective function using user interfaces provided by the design parameter setting means 210, the constraint condition setting means 220, and the objective function setting means 230 (S410, S420, and S430).

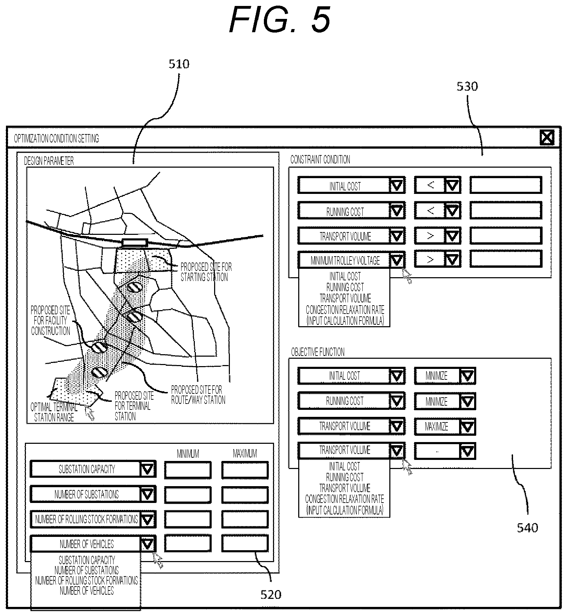

FIG. 5 illustrates examples of the user interfaces provided by the design parameter setting means 210, the constraint condition setting means 220, and the objective function setting means 230 in the present example.

For example, the user designates a range in which a starting station, a way station, a terminal station, or a facility such as a substation can be constructed on the map of the city where the railroad system is constructed using the user interface provided by the design parameter setting means 210 (510). For example, a range of a design parameter, etc. which cannot be designated as a range on the map is designated through a user interface illustrated in 520.

In addition, the user designates a parameter of the traffic system serving as a constraint condition, designates a maximum value or a minimum value thereof, or inputs an equation serving as the constraint condition using the user interface provided by the constraint condition setting means 220 (530).

In addition, the user designates a parameter of the traffic system serving as an objective function or inputs a calculation formula for calculation of the objective function using the user interface provided by the objective function setting means 270 (540).

In FIG. 5, the user interfaces provided by the design parameter setting means 210, the constraint condition setting means 220, and the objective function setting means 270 are displayed on the same screen. However, the user interfaces may be displayed on separate screens.

Subsequently, the design parameter optimization means sets the design parameter to an appropriate value (S440).

Subsequently, the rail service simulation means 250 estimates power consumption or a transport volume of the railroad system in the value of the design parameter set in S440 (S450).

Subsequently, the cost calculation means 260 calculates the initial cost or the running cost of the railroad system using a result of the rail service simulation means 250, the data recorded in the cost database 2110, etc. (S460).

Subsequently, the objective function calculation means 270 calculates an objective function value based on a parameter or a calculation formula designated by the user through the objective function setting means 230 using calculation results of S450 and S460 (S470).

When the objective function value is calculated, the present device determines whether the design parameter is an optimal value from the objective function value, a change in the objective function value, etc. When the design parameter is determined to be not optimum, the design parameter optimization means 240 changes the value of the design parameter to an appropriate value (S440), and executes S450 to S470 again.

When the design parameter is determined to be optimum, the analogous optimal solution grouping means 280 groups a plurality of optimal solutions analogous to each other obtained as a result of S440 to S470 (S480). Specifically, a difference $d_{ij}$ between two optimal solutions i and j is calculated by Equation 1 using objective function values of the optimal solutions, and optimal solutions, a difference of which is small, are grouped using, for example, the clustering method such as the widely known k-mean method.

[Equation 1]

$$d_{ij} = \sqrt{\sum_{k=1}^{n} \left( y_{ki} - y_{kj} \right)}$$

(Equation 1)

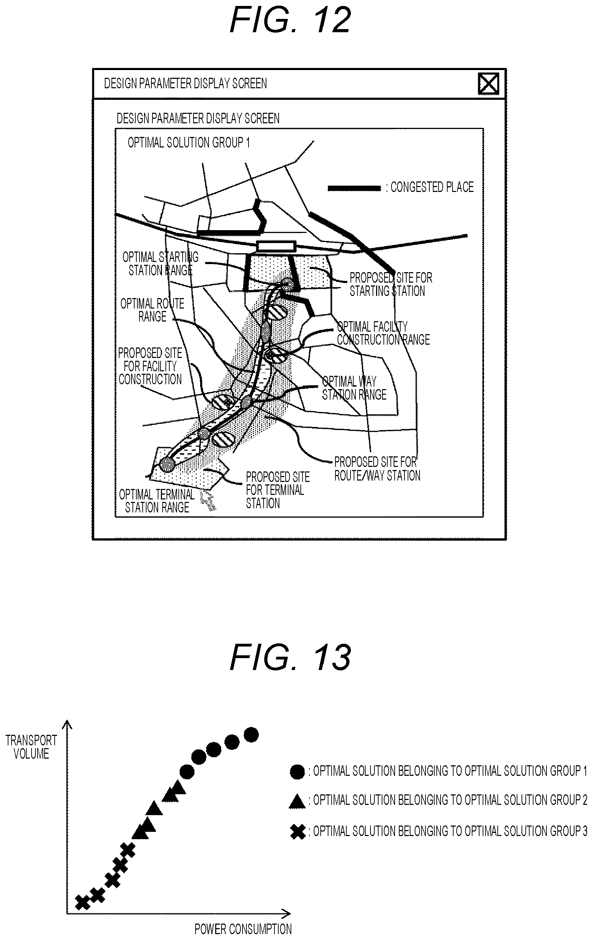

Herein, $y_{ki}$ denotes a value of a k-th objection function of an i-th optimal solution, and $y_{kj}$ denotes a value of a k-th objection function of a j-th optimal solution. For example, when optimization is performed by setting the transport volume and the power consumption of the railroad system as objective functions, and a pareto solution illustrated in FIG. 13 is obtained, the analogous optimal solution grouping means 280 calculates a difference between optimal solutions using Equation 1, and groups optimal solutions analogous to each other such that the number of groups designated by the user is obtained. As a result, for example, as illustrated in FIG. 13, optimal solutions are grouped into an optimal solution group 1, an optimal solution group 2, and an optimal solution group 3. In the above example, only a value of an objective function is used to express a difference between optimal solutions. However, a value of a design parameter may be simultaneously used.

Subsequently, the user displays the optimal solutions grouped by the analogous solution optimal solution grouping means 280 using the pareto solution display means 290 and the optimal solution details display means 2100.

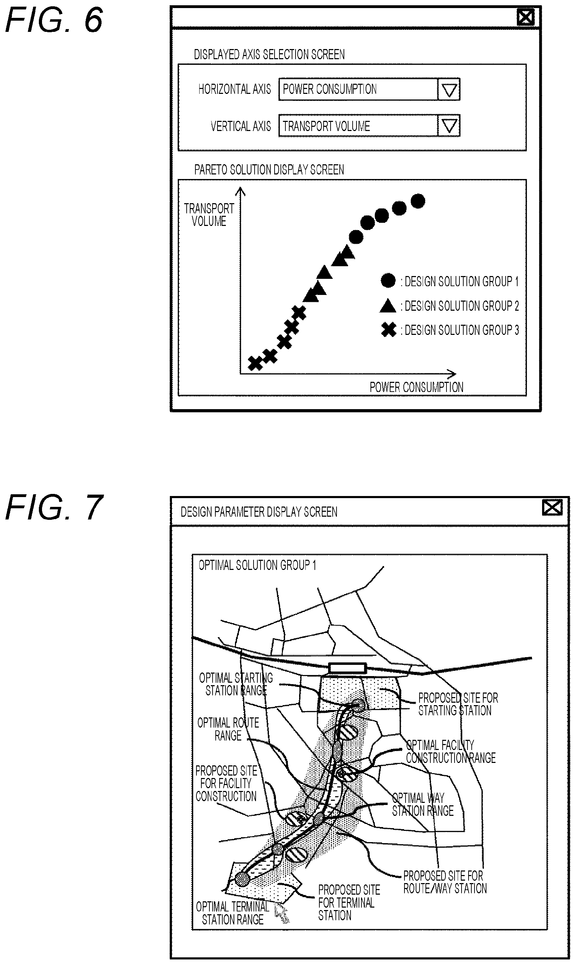

Specifically, the user selects an axis to be displayed and displays an optimal solution obtained as a result of optimization using the user interface provided by the pareto solution display means 290 (S490). An example of display of an optimal solution by the pareto solution display means 2100 is illustrated in FIG. 6. FIG. 6 illustrates a result obtained by performing optimization by setting the transport volume and the power consumption of the railroad system as objective functions, and grouping pareto solutions obtained as a result of optimization into three optimal solution groups. In this example, the pareto solutions are displayed using different markers among the optimal solution groups.

The user may display detailed information of an optimal solution group using the optimal solution details display means 2100 by selecting a design solution group from the user interface provided by the pareto solution display means 290, etc. (S4100).

An example thereof is illustrated in FIG. 7. As illustrated in FIG. 7, among design parameters of an optimal solution belonging to an optimal solution group, a design parameter which can be displayed on a map is displayed as a range on the map.

According to the present example described above, the user may determine a location at which a station, a track, a facility, etc. of the railroad system are to be installed, and may flexibly respond to a case in which an installation location needs to be changed due to various reasons since the location is displayed as a range.

Example 2

Hereinafter, a description will be given of Example 2 corresponding to a second embodiment of the invention. The present example is an example of a traffic system optimization device capable of performing optimization of specifications in consideration of an influence on a traffic condition of a city where a traffic system is constructed in addition to evaluation of an initial cost and a running cost of a traffic system such as a railroad system. In description below, a railroad system which is a traffic system will be given as an example, and a device for optimizing the railroad system will be described. However, a traffic system to be optimized by the traffic system optimization device of the invention is not restricted to the railroad system.

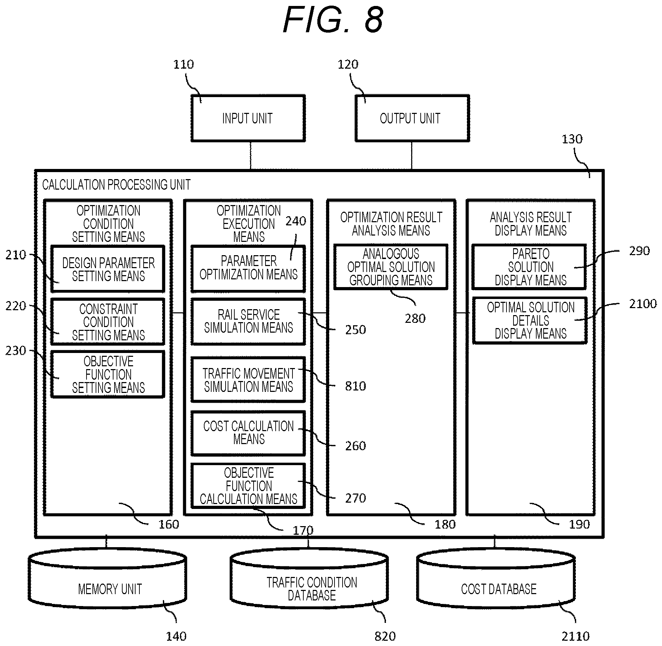

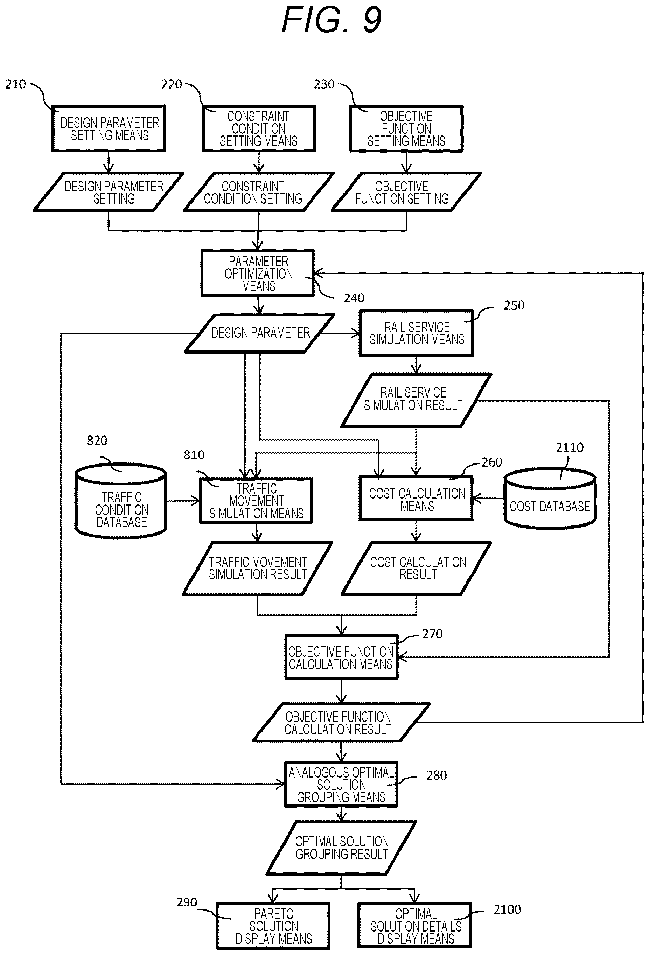

FIG. 8 is an example of a block diagram illustrating the traffic system optimization device in the present example. In addition, FIG. 9 is a flow of main data in processing of the present example.

In the traffic system optimization device illustrated in FIG. 8 and FIG. 9, description of a previously described configuration to which the same reference numeral as that illustrated in FIG. 2 is assigned and a part having the same function will be omitted.

The traffic system optimization device in the present example mainly includes an input unit 110, an output unit 120, a calculation processing unit 130, a memory unit 140, a traffic condition database 820, and a cost database 2110. These units may be connected to each other through a network such as the Internet, an intranet, etc.

Data related to a traffic condition of a city where the railroad system is constructed is recorded in the traffic condition database 820. Here, the data corresponds to a traffic volume at each intersection or on a road, etc.

An optimization execution means 170 includes a design parameter optimization means 240, a rail service simulation means 250, a traffic movement simulation means 810, a cost calculation means 260, and an objective function calculation means 270.

The traffic movement simulation means 810 evaluates a change in a congestion condition on a road before and after the traffic system is constructed, etc. based on the data recorded in the traffic condition database 820, a simulation result of the rail service simulation means 250, and a design parameter value given by the parameter optimization means 240 using, for example, the technology described in PTL 2.

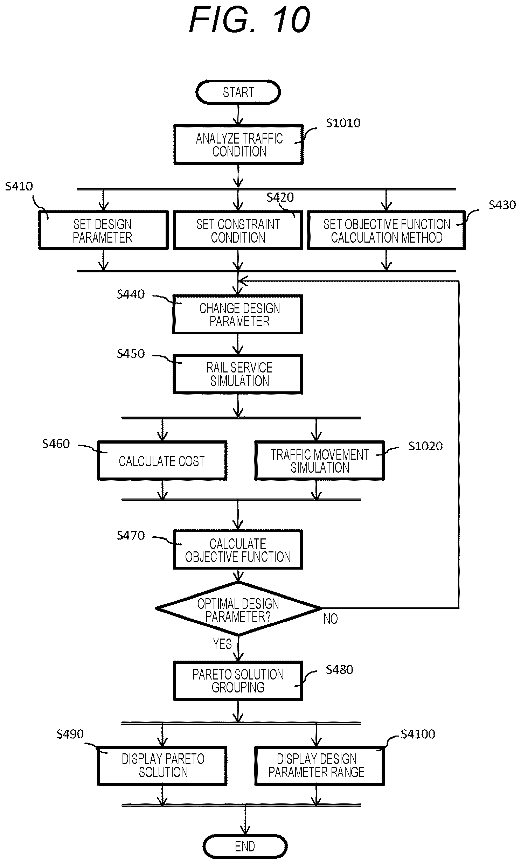

Next, a description will be given of a flow of processing of the present example. FIG. 10 illustrates the flow of processing in the present example. It is presumed that the same process is performed in FIG. 10 in a previously described processing step to which the same reference numeral as that illustrated in FIG. 4 is assigned in a traffic system optimization device illustrated in FIG. 10 unless otherwise particularly mentioned.

First, in the present example, the traffic movement simulation means estimates a congestion condition on a road of a city before the railroad system is constructed using the data of the traffic condition database (S1010).

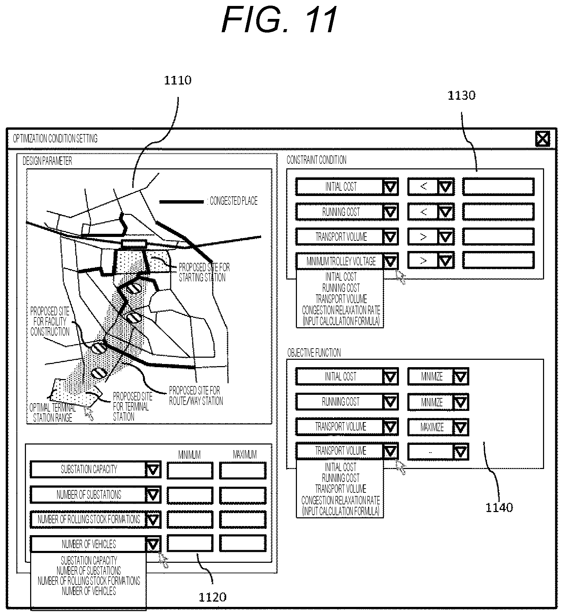

In processing steps S410, S420, and S430, the user sets a design parameter, a constraint condition, and an objective function using user interfaces provided by a design parameter setting means, a constraint condition setting means, and an objective function setting means. Examples of the user interfaces at this time are illustrated in FIG. 11.

In the present example, for example, a congestion condition on the road of the city before the railroad system is constructed may be displayed on a screen (for example, a map, etc.), on which a range of a design parameter, etc. can be designated, and a range of the design parameter may be designated on the screen (1110). For example, a range of a design parameter which cannot be designated as a range on the map is designated through a user interface illustrated in 1120.

In addition, the user designates a parameter of the traffic system serving as a constraint condition, designates a maximum value or a minimum value thereof, or inputs an equation serving as the constraint condition using a user interface provided by the constraint condition setting means 220 (1130).

In addition, the user designates a parameter of the traffic system serving as an objective function or inputs a calculation formula for calculation of the objective function using the user interface provided by the objective function setting means 270 (1140).

In processing step S1020, the traffic movement simulation means 810 estimates a change in a congestion condition on the road due to an influence of construction of the railroad system based on a result of the rail service simulation means 250, the date recorded in the traffic condition database 820, the design parameter, etc. (S1020).

In processing step S4100, detailed information of each optimal solution group is displayed by the optimal solution details display means 2100. An example thereof is illustrated in FIG. 12. As illustrated in FIG. 12, in the present example, the congestion condition on the road of the city after the railroad system is constructed may be displayed in addition to a range of a design parameter of an optimal solution group.

According to the present example described above, the user may determine a location at which a station, a track, a facility, etc. of the railroad system are to be installed after determining the degree of improvement of a traffic condition of the city by the railroad system.

Reference Signs List

110 input unit
120 output unit
130 calculation processing unit
140 memory unit
160 optimization condition setting means
170 optimization execution means
180 optimization result analysis means
190 analysis result display means
210 design parameter setting means
220 constraint condition setting means
230 objective function setting means
240 parameter optimization means
250 rail service simulation means
260 cost calculation means
270 objective function calculation means
280 analogous optimal solution grouping means
290 pareto solution display means
2100 optimal solution details display means
2110 cost database
510 user interface for designating range in which facility can be constructed on map
520 user interface for designating parameter that cannot be designated on map
530 user interface for designating parameter of constraint condition

540 user interface for designating parameter of objective function
810 traffic movement simulation means
820 traffic condition database
1110 user interface for designating range of design parameter on map
1120 user interface for designating parameter that cannot be designated on map
1130 user interface for designating parameter of constraint condition
1140 user interface for designating parameter of objective function

**Claims**

1. A traffic system optimization device comprising:

an optimization condition setting unit that has a function of designating a condition as a range on a map when specifications of a traffic system are optimized;
an optimization execution unit that optimizes the specifications of the traffic system by a simulation using a calculator under an optimization condition set by the optimization condition setting unit;
an optimization result analysis unit that groups optimal solutions analogous to each other obtained by the optimization execution unit; and
an analysis result display unit that has at least a function of displaying a range of a design variable for each group of an optimal solution grouped by the optimization result analysis unit on the map.

2. The traffic system optimization device according to claim 1,
wherein the optimization condition setting unit includes:

a cost database in which at least one of data necessary to determine an initial cost of a railroad system and data necessary to determine a running cost of the railroad system is recorded;
a design parameter setting unit that has a function of determining a specification to be set as a design parameter and optimized among specifications of the railroad system, and designating a range thereof on a map;
a constraint condition setting unit that sets a constraint condition in optimization; and
an objective function setting unit that sets an objective function in optimization,

the optimization execution unit includes:

a parameter optimization unit;
a rail service simulation unit that calculates at least one of power consumption and transportation capacity of the railroad system in a given design parameter;
a cost calculation unit that calculates at least one of an initial cost and a running cost of the traffic system based on at least one of the data recorded in the cost database, a design parameter given by the parameter optimization unit, and an output of the rail service simulation unit; and
an objective function calculation unit that calculates a value of an objective function according to a method of calculating an objective function set by the objective function setting unit based on at least one of an output of the rail service simulation unit and an output of the cost calculation unit,

the optimization result analysis unit includes an analogous optimal solution grouping unit that groups analogous optimal solutions using a clustering method, and
the analysis result display unit includes:

a pareto solution display unit that displays a pareto solution obtained by the optimization execution unit and an optimal solution group to which each pareto solution belongs on a graph using a variable set by a user as an axis; and
an optimization details display unit that displays various detailed information of each optimal solution group on a map.

3. The traffic system optimization device according to claim 2, further comprising
a traffic condition database in which data related to a traffic condition of a city where the traffic system is constructed is recorded, the data pertaining to a traffic volume in at least a portion of a traffic system component including each intersection and a road,

wherein the optimization execution unit includes a traffic movement simulator that evaluates a change in a congestion condition on a road before and after the traffic system is constructed.

4. A traffic system optimization device comprising:

an optimization condition setting means that has a function of designating a condition as a range on a map when specifications of a traffic system are optimized;
an optimization execution means that optimizes the specifications of the traffic system by a simulation using a calculator under an optimization condition set by the optimization condition setting means;
an optimization result analysis means that groups optimal solutions analogous to each other obtained by the optimization execution means; and
an analysis result display means that has at least a function of displaying a range of a design variable for each group of an optimal solution grouped by the optimization result analysis means on the map.

5. The traffic system optimization device according to claim 4,
wherein the optimization condition setting means includes:

a cost database in which data necessary to determine an initial cost of a railroad system such as a price of each component of the railroad system and data necessary to determine a running cost of the railroad system such as electric charges or personnel expenses are recorded;
a design parameter setting means that has a function of determining a specification to be set as a design parameter and optimized among specifications of the railroad system, and designating a range thereof on a map;
a constraint condition setting means that sets a constraint condition in optimization; and
an objective function setting means that sets an objective function in optimization,

the optimization execution means includes:

a rail service simulation means that calculates power consumption or transportation capacity of the railroad system in a given design parameter;
a cost calculation means that calculates an initial cost or a running cost of the traffic system based on the data recorded in the cost database, a design parameter given by a parameter optimization means, and a result of the rail service simulation means; and
an objective function calculation means that calculates a value of an objective function according to a method of calculating an objective function set by the objective function setting means based on a result of the rail service simulation means or the cost calculation means,

the optimization result analysis means includes an analogous optimal solution grouping means that groups analogous optimal solutions using a clustering method, and
the analysis result display means includes:

a pareto solution display means that displays a pareto solution obtained by the optimization execution means and an optimal solution group to which each pareto solution belongs on a graph using a variable set by a user as an axis; and
an optimization details display means that displays various detailed information of each optimal solution group on a map.

6. The traffic system optimization device according to claim 5, further comprising
a traffic condition database in which data related to a traffic condition of a city where the traffic system is constructed is recorded, the data pertaining to a traffic volume in at least a portion of a traffic system component including each intersection and a road,
wherein the optimization execution means includes a traffic movement simulator that evaluates a change in a congestion condition on a road before and after the traffic system is constructed.

# FIG. 1

# FIG. 2

# FIG. 3

# FIG. 4

```
                        START

S410                       S420
                                          S430
   SET DESIGN      SET CONSTRAINT    SET OBJECTIVE FUNCTION
   PARAMETER          CONDITION      CALCULATION METHOD


S440          CHANGE DESIGN
                PARAMETER


S450          RAIL SERVICE
               SIMULATION


S460          CALCULATE COST


S470          CALCULATE
            OBJECTIVE FUNCTION


              OPTIMAL DESIGN
               PARAMETER?            NO

                 YES

            PARETO SOLUTION      S480
               GROUPING


S490                                 S4100
   DISPLAY PARETO      DISPLAY DESIGN
     SOLUTION        PARAMETER RANGE


                        END
```

EP 3 135 556 A1

# FIG. 5

13

## FIG. 6

DISPLAYED AXIS SELECTION SCREEN

HORIZONTAL AXIS | POWER CONSUMPTION | ▽

VERTICAL AXIS | TRANSPORT VOLUME | ▽

PARETO SOLUTION DISPLAY SCREEN

TRANSPORT VOLUME

● : DESIGN SOLUTION GROUP 1
▲ : DESIGN SOLUTION GROUP 2
✖ : DESIGN SOLUTION GROUP 3

POWER CONSUMPTION

## FIG. 7

DESIGN PARAMETER DISPLAY SCREEN

OPTIMAL SOLUTION GROUP 1

OPTIMAL STARTING STATION RANGE

PROPOSED SITE FOR STARTING STATION

OPTIMAL ROUTE RANGE

OPTIMAL FACILITY CONSTRUCTION RANGE

PROPOSED SITE FOR FACILITY CONSTRUCTION

OPTIMAL WAY STATION RANGE

PROPOSED SITE FOR ROUTE/WAY STATION

OPTIMAL TERMINAL STATION RANGE

PROPOSED SITE FOR TERMINAL STATION

# FIG. 8

# FIG. 9

# FIG. 10

START

S1010 — ANALYZE TRAFFIC CONDITION

S410 — SET DESIGN PARAMETER

S420 — SET CONSTRAINT CONDITION

S430 — SET OBJECTIVE FUNCTION CALCULATION METHOD

S440 — CHANGE DESIGN PARAMETER

S450 — RAIL SERVICE SIMULATION

S460 — CALCULATE COST

S1020 — TRAFFIC MOVEMENT SIMULATION

S470 — CALCULATE OBJECTIVE FUNCTION

OPTIMAL DESIGN PARAMETER? — NO

YES

S480 — PARETO SOLUTION GROUPING

S490 — DISPLAY PARETO SOLUTION

S4100 — DISPLAY DESIGN PARAMETER RANGE

END

# FIG. 11

1110

1130

**OPTIMIZATION CONDITION SETTING**

**DESIGN PARAMETER**

━━━ : CONGESTED PLACE

PROPOSED SITE FOR STARTING STATION

PROPOSED SITE FOR FACILITY CONSTRUCTION

PROPOSED SITE FOR ROUTE/WAY STATION

OPTIMAL TERMINAL STATION RANGE

PROPOSED SITE FOR TERMINAL STATION

|  | MINIMUM | MAXIMUM |
|---|---|---|
| SUBSTATION CAPACITY ▽ | | |
| NUMBER OF SUBSTATIONS ▽ | | |
| NUMBER OF ROLLING STOCK FORMATIONS ▽ | | |
| NUMBER OF VEHICLES ▽ | | |

SUBSTATION CAPACITY
NUMBER OF SUBSTATIONS
NUMBER OF ROLLING STOCK FORMATIONS
NUMBER OF VEHICLES

1120

**CONSTRAINT CONDITION**

| INITIAL COST ▽ | < ▽ | |
| RUNNING COST ▽ | < ▽ | |
| TRANSPORT VOLUME ▽ | > ▽ | |
| MINIMUM TROLLEY VOLTAGE ▽ | > ▽ | |

INITIAL COST
RUNNING COST
TRANSPORT VOLUME
CONGESTION RELAXATION RATE
(INPUT CALCULATION FORMULA)

**OBJECTIVE FUNCTION**

| INITIAL COST ▽ | MINIMIZE ▽ |
| RUNNING COST ▽ | MINIMIZE ▽ |
| TRANSPORT VOLUME ▽ | MAXIMIZE ▽ |
| TRANSPORT VOLUME ▽ | -- ▽ |

INITIAL COST
RUNNING COST
TRANSPORT VOLUME
CONGESTION RELAXATION RATE
(INPUT CALCULATION FORMULA)

1140

# FIG. 12

DESIGN PARAMETER DISPLAY SCREEN ☒

DESIGN PARAMETER DISPLAY SCREEN

OPTIMAL SOLUTION GROUP 1

━━━ : CONGESTED PLACE

OPTIMAL STARTING STATION RANGE

OPTIMAL ROUTE RANGE

PROPOSED SITE FOR FACILITY CONSTRUCTION

OPTIMAL TERMINAL STATION RANGE

PROPOSED SITE FOR TERMINAL STATION

PROPOSED SITE FOR STARTING STATION

OPTIMAL FACILITY CONSTRUCTION RANGE

OPTIMAL WAY STATION RANGE

PROPOSED SITE FOR ROUTE/WAY STATION

# FIG. 13

TRANSPORT VOLUME

POWER CONSUMPTION

● : OPTIMAL SOLUTION BELONGING TO OPTIMAL SOLUTION GROUP 1

▲ : OPTIMAL SOLUTION BELONGING TO OPTIMAL SOLUTION GROUP 2

✖ : OPTIMAL SOLUTION BELONGING TO OPTIMAL SOLUTION GROUP 3

**INTERNATIONAL SEARCH REPORT**

| International application No. |
|---|
| PCT/JP2014/061114 |

| A. CLASSIFICATION OF SUBJECT MATTER |
|---|
| *B61L27/00*(2006.01)i, *G08G1/00*(2006.01)i |

According to International Patent Classification (IPC) or to both national classification and IPC

| B. FIELDS SEARCHED |
|---|

Minimum documentation searched (classification system followed by classification symbols)
B61L27/00, G08G1/00

Documentation searched other than minimum documentation to the extent that such documents are included in the fields searched
Jitsuyo Shinan Koho        1922–1996   Jitsuyo Shinan Toroku Koho   1996–2014
Kokai Jitsuyo Shinan Koho  1971–2014   Toroku Jitsuyo Shinan Koho   1994–2014

Electronic data base consulted during the international search (name of data base and, where practicable, search terms used)

| C. DOCUMENTS CONSIDERED TO BE RELEVANT |
|---|

| Category* | Citation of document, with indication, where appropriate, of the relevant passages | Relevant to claim No. |
|---|---|---|
| A | JP 2012-43066 A  (Toyota InfoTechnology Center, Co., Ltd., Toyota Motor Corp.), 01 March 2012 (01.03.2012), entire text; all drawings (Family: none) | 1-6 |
| A | JP 2003-272085 A  (Toshiba Corp.), 26 September 2003 (26.09.2003), entire text; all drawings (Family: none) | 1-6 |
| A | JP 2012-198839 A  (Denso IT Laboratory, Inc.), 18 October 2012 (18.10.2012), entire text; all drawings & CN 102693627 A | 1-6 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 09 July, 2014 (09.07.14) | 22 July, 2014 (22.07.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

# EP 3 135 556 A1

**INTERNATIONAL SEARCH REPORT**

| International application No. |
| --- |
| PCT/JP2014/061114 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2001-354139 A  (Hitachi, Ltd., Kabushiki Kaisha Hitachi Joho Seigyo System), 25 December 2001 (25.12.2001), entire text; all drawings (Family: none) | 1-6 |

Form PCT/ISA/210 (continuation of second sheet) (July 2009)

21

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006254536 A
- JP 2013137715 A